# EUROPEAN PATENT APPLICATION

(11) **EP 4 446 838 A2**
(43) Date of publication of application: **16.10.2024**
(21) Application number: 24156149.7
(22) Date of filing: 06.02.2024
(51) Int. Cl.: G05B 23/02, G04G 19/06, H02J 3/12, G01R 31/40, G05F 1/66

(54) **DIAGNOSTIC TOOL FOR AN ELECTRICAL SYSTEM**

(30) Priority: 17.02.2023 US 202363446466 P
(71) Applicant: Eaton Intelligent Power Limited, Dublin 4, D04 Y0C2 (IE)
(72) Inventor: DALEY, Daniel Joseph, Waukesha, 53188 (US)
(74) Representative: Schwan Schorer & Partner mbB

(57) **Abstract**

A control system includes a data monitoring module configured to: obtain one or more status indicators of a voltage regulation system, each status indicator corresponding to an operating parameter of the voltage regulation system; determine a state value of each status indicator at a second time; compare the state value of each status indicator to a state value for that status indicator at a first time, the first time occurring before the second time; determine whether any operating parameter of the voltage regulation system changed state based on the comparison; and if any operating parameter of the voltage regulation system changed state, store a record in a dataset, the record including the state value of all of the status indicators and a time stamp that includes the second time.

## Description

### CROSS-REFERENCE TO RELATED APPLICATION

This application claims the benefit of U.S. Provisional Application No. 63/446,466, filed on February 17, 2023 and titled DIAGNOSTIC TOOL FOR AN ELECTRICAL SYSTEM, which is incorporated herein by reference in its entirety.

### TECHNICAL FIELD

This disclosure relates to a diagnostic tool for an electrical system, such as, for example, a voltage regulation system.

### BACKGROUND

Voltage regulation devices are used to monitor and control a voltage level in an electrical power distribution system.

### SUMMARY

In one aspect, a control system includes a data monitoring module configured to: obtain one or more status indicators of a voltage regulation system, each status indicator corresponding to an operating parameter of the voltage regulation system; determine a state value of each status indicator at a second time; compare the state value of each status indicator to a state value for that status indicator at a first time, the first time occurring before the second time; determine whether any operating parameter of the voltage regulation system changed state based on the comparison; and if any operating parameter of the voltage regulation system changed state, store a record in a dataset, the record including the state value of all of the status indicators and a time stamp that includes the second time.

Implementations may include one or more of the following features.

The status indicators may include regulator status indicators that correspond to operating parameters of a voltage regulation device coupled to the control system and control status indicators that correspond to operating parameters of the control system.

The data monitoring module also may be configured to provide the dataset to a separate device. The data monitoring module may be configured to provide the dataset to the separate device using the SCADA protocol.

The data monitoring module may be further configured to provide the dataset to a display module that is configured to visually present oscillography based on the dataset. The display module may be part of the control system. The display module may visually present the oscillography at the voltage regulation device. The display module may visually present the oscillography at the separate device.

The control status indicators may include one or more of an indicator related to an operating status of the control, an indicator related to a command issued by the control, an indicator related to a command received by the voltage regulation device, and an indicator related to a monitored value.

The control status indicators may include one or more indicators that are determined based on a plurality of other status indicators.

In another aspect, a method includes: monitoring the state of one or more operating parameters of an electrical system during an observation period to detect changes in the state of the operating parameters; and in response to detecting a change in the state of any of the one or more operating parameters at a time in the observation period: generating a record that includes one or more values and a time stamp, the one or more values each representing the state of one operating parameter at the time in the observation period and the time stamp including the time in the observation period; and adding the generated record to a dataset such that the dataset includes records of state changes.

Implementations may include one or more of the following features. The method also may include generating oscillography data based on the dataset and presenting a virtual oscilloscope trace based on the oscillography data.

Monitoring the state of the operating parameters may include monitoring status indicators corresponding to the one or more operating parameters, and detecting changes in the state of a particular one of the operating parameters may include comparing a state value of the status indicator corresponding to that operating parameter at a later time to the state value of that status indicator at an earlier time.

In another aspect, a system includes: a data management module configured to:
obtain a dataset that includes records, each record representing a state change of at least one operating parameter of an electrical system, each record including state values of the operating parameters and a time stamp, each time stamp being a time when a state change for at least one operating parameter was detected; and prepare oscillography data from the dataset by generating at least one filler record and adding the least one filler record between a first record in the dataset and a second record in the dataset, the first record having an earlier time stamp than the second record, and the filler record including the same state values as the first record and a time stamp between the time stamp of the first record and the time stamp of the second record. The system also includes a visualization module configured to present a graph including the values in the oscillography data plotted as a function of time for the observation period.

Implementations may include one or more of the following features.

The time stamps in the oscillography data may be times that are equally spaced in time, and the time stamps in the dataset are not equally spaced in time.

The visualization module may be further configured to visually present the time stamps of the dataset to thereby provide temporal labels for state transitions.

Each record may represent a state change of at least one operating parameter of a voltage regulator.

Implementations of any of the techniques described herein may include a voltage regulation device, a system that includes an electrical mechanism and a control system, software stored on a non-transitory computer readable medium that, when executed, controls a voltage regulation device, a kit for retrofitting a voltage regulation device, a software update for a control system of a voltage regulation device, a data analysis and display tool, and/or a method. The details of one or more implementations are set forth in the accompanying drawings and the description below. Other features will be apparent from the description and drawings, and from the claims.

### DRAWING DESCRIPTION

FIG. 1 is a block diagram of an example of an electrical power system.
FIG. 2 is a block diagram of an example of a voltage regulation system.
FIG. 3 is a flow chart of an example of a process for building the dataset.
FIG. 4 is an example of a dataset.
FIG. 5 is a flow chart of an example of a process for generating oscillography from a dataset.
FIG. 6 is an example of a virtual oscilloscope plot.
FIG. 7 is another example of a dataset.

### DETAILED DESCRIPTION

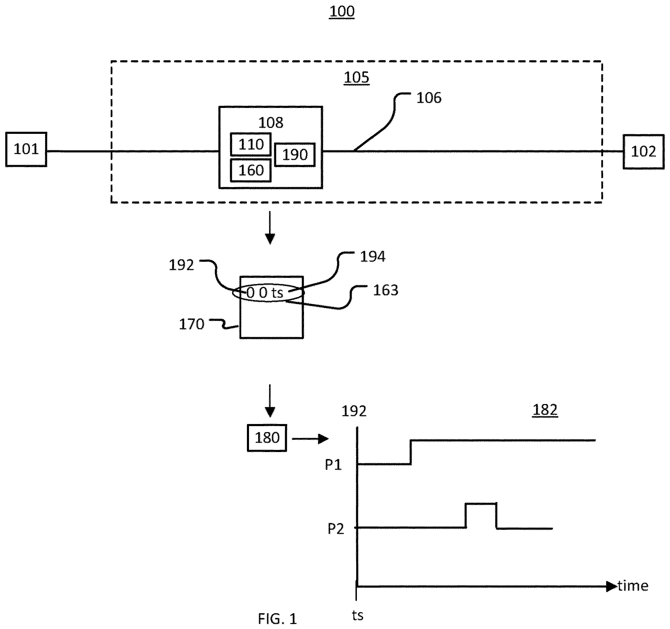

Referring to FIG. 1, a block diagram of an example of an electrical power system 100 is shown. The power system 100 includes an electrical power distribution network 105, which distributes electricity from power sources 101 to electrical loads 102 via a distribution path 106. The power system 100 includes an electrical system 108. The electrical system 108 is any type of electrical system that includes an electrical mechanism 110 and a control 160 that monitors and/or activates the electrical mechanism 110. In the examples discussed below, the electrical system 108 is a voltage regulation system 108.

The voltage regulation system 108 includes a voltage regulation device 110 and a control 160. The control 160 monitors and controls the voltage regulation device 110. The control 160 also generates a dataset 170 that may be used by a data analysis tool 180 to produce a virtual oscilloscope trace 182. The trace 182 is referred to as a virtual oscilloscope trace because, although the trace is a plot of a signal over time like traces displayed by a traditional oscilloscope, the data in the dataset 170 (which is used to make the trace 182) is not collected by a traditional oscilloscope. As discussed in more detail below, the dataset 170 is more compact (smaller in size), easier to transmit, and provides more meaningful data as compared to data generated by a traditional oscilloscope.

The voltage regulation system 108 monitors and adjusts the voltage level in the power distribution network 105. For example, the voltage regulation system 108 may be used to maintain a steady-state voltage of the electrical power distribution network 105, or of a portion of the network 105, within a voltage range such that the voltage level at the load 102 also stays within an acceptable range. The voltage regulation system 108 may be any type of electrical, mechanical, or electro-mechanical device that is capable of performing a voltage regulation operation that changes the voltage on the distribution path 106. The voltage regulation system 108 may be, for example, a on load-tap changer (OLTC) or a step voltage regulator.

The voltage regulation system 108 is associated with one or more status indicators 190. The status indicators 190 are electrical signals (for example, voltage or current signals) or status flags that provide information about operating parameters of the voltage regulation system. The control 160 monitors the status indicators 190 for state changes and only includes data associated with a state change of at least one status indicator 190 in the dataset 170.

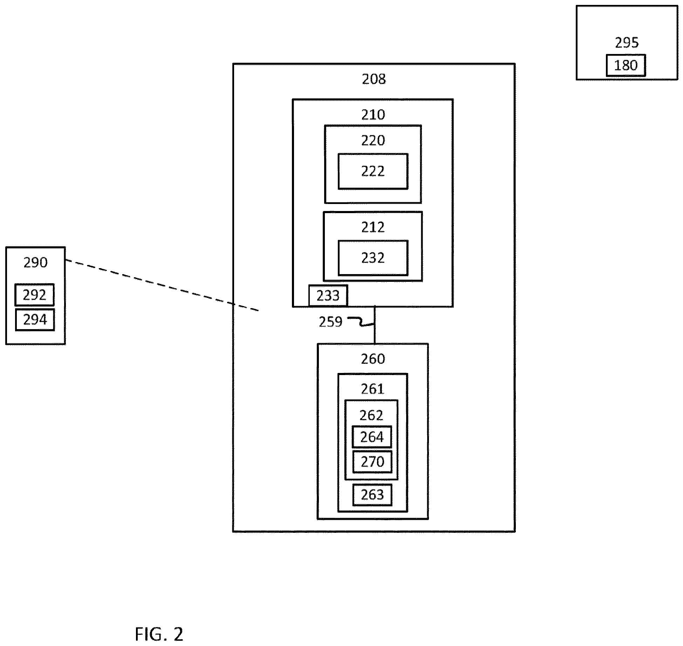

Each status indicator 190 is a measurable or observable quantity that relates to an operating parameter of the voltage regulation system 108. The status indicators 190 may include regulator indicators, which are related to operating parameters of the voltage regulation device 110, and/or control indicators, which are related to operating parameters of the control 160. Specific examples of the status indicators 190 are discussed below with respect to FIGS. 2-4.

Each status indicator 190 has a state that is detectable by the control 160. For status indictors 190 that are continuous electrical signals, the control 160 detects the state of the status indicator 190 at a particular time by comparing the amplitude of the status indicator 190 at that time to a threshold or specification. For status indicators 190 that are binary values or flags, the control 160 determines the state of the status indicator 190 based on the value of the status indicator 190.

When the control 160 detects a state change of any of the status indicators 190, the control 160 initiates a record-generating event such that one record (for example, the record labeled 163 in FIG. 1) is generated and added to the dataset 170. The record 163 includes state values 192 that represent the state each status indicator 190 and a time stamp 194. In the example shown in FIG. 1, two status indicators 190 (corresponding to parameters P1 and P2) are monitored, and the record 163 includes a state value for each status indicator 190. The time stamp 194 is the time when the record-generating event was initiated (which also corresponds to the time of the state change of the status indicator 190). The control 160 only initiates a record-generating event and only adds a record to the dataset 170 when at least one of the status indicators 190 changes state. A record is not generated or stored in the dataset 170 when none of the status indicators 190 change state. In this way, the dataset 170 is compact, conserves memory resources, and may be efficiently shared with a separate device.

The control 160 monitors the status indicators 190 over an observation period and adds an additional record to the dataset 170 each time a state change is detected. After the observation period ends, the dataset 170 is provided to the analysis tool 180 and used to generate the virtual oscilloscope trace 182. The virtual oscilloscope trace 182 shows the status indicators 190 as a function of time.

The dataset 170 and the analysis tool 180 provide an efficient and effective approach to troubleshooting and diagnosing error conditions of the voltage regulation system 108. One traditional approach to troubleshooting and diagnosing error conditions in the voltage regulation device 110 is to electrically connect an external digital oscilloscope to a wired connection between the voltage regulation device 110, to circuitry inside of the voltage regulation device 110, and/or to circuitry in the control 160. With this approach, the external oscilloscope presents an oscillograph display (or oscilloscope trace) of the status indicators 190 on the screen of the external oscilloscope and/or at another interface.

However, observing the status indicators 190 with an external oscilloscope presents several challenges. First, this approach entails the use of an external oscilloscope, which may be expensive to procure and maintain and complex to operate. Second, relying on an external digital oscilloscope to observe the status indicators 190 requires a skilled technician or engineer to be dispatched to the voltage regulation system 108 for an in-person service call, and also may require additional technical personnel to be available remotely or in-person to provide support and guidance to the technician or engineer during the service call. Third, as external digital oscilloscopes have a finite number of channels, depending on the number of operating parameters of interest, it is also possible that not all of the status indicators 190 can be monitored by the external oscilloscope at the same time. Fourth, due to various safety features, electrical design, space requirements, and electrical shielding in the voltage regulation system 108, points where the status indicators 190 may be observed or measured are not always readily accessible for connection to an external oscilloscope.

Moreover, an approach that avoids an external oscilloscope by integrating a digital oscilloscope into the control 160 or into another part of the voltage regulation system 108 also may present challenges because of the way in which traditional oscilloscopes operate. For example, oscilloscopes capture data by recording a digitized sample over a fixed period of time before, during, and after a trigger. Thus, a large portion of the data captured by an integrated oscilloscope (or an external oscilloscope) is redundant or otherwise not useful for data analysis, is inefficient or impractical to store at the voltage regulation system 108, and is potentially challenging to transmit to a separate device. Furthermore, an oscilloscope is limited in the number of signals that may be used for the trigger, and this further limits the amount of meaningful data that can be obtained during a given observation period. Finally, the data captured by an oscilloscope is sampled at a constant rate, making it difficult or impossible to determine when a state change that happened between two consecutive samples actually occurred.

On the other hand, the control 160 produces the dataset 170, which includes only records that have a state change of at least one status indicator 190. In this way, for a given observation period, the dataset 170 is smaller in size than the data that would be collected by a traditional oscilloscope over that same observation period. As a result, as compared to data produced by a traditional oscilloscope, the dataset 170 may be more efficiently stored and more efficiently transferred to a separate device. Furthermore, because the generation of the records in the dataset 170 is driven by a state change of any one of the status indicators 190, instead of by a single or subset amount of triggers, the dataset 170 can capture state changes more precisely than a traditional oscilloscope. Finally, because the state values of the status indicators 190 remain constant between consecutive records, the tool 180 is able to produce the virtual oscilloscope trace 182 from the dataset 170. Accordingly, the control 160 offers a way to diagnose errors and troubleshoot the voltage regulation system 108 without a traditional oscilloscope and the dataset 170 provides a more accurate analysis than is possible with data from a traditional oscilloscope.

FIG. 2 is a block diagram of a voltage regulation system 208. The voltage regulation system 208 is an example of an implementation of the voltage regulation system 108, and the voltage regulation system 208 may be used in the system 100.

The voltage regulation system 208 includes a voltage regulation device 210 that is controlled and monitored by a control 260. The control 260 generates a dataset 270. The voltage regulation device 210 includes a tap changing mechanism 212, and a coil or a transformer 220 that includes taps 222. The tap changing mechanism 212 includes one or more electrical contacts 232 that are moveable relative to the coil 220 and a device 231 (such as a motor) that moves the electrical contacts 232 to perform a tap change operation. The coil 220 is electrically connected to a load (such as the load 102 of FIG. 1) when at least one of the taps 222 is in contact with the electrical contacts 232. The amount of voltage provided to the load depends on which of the taps 222 are in electrical contact with the contacts 232. The position of the contacts 232 relative to the taps 222 is the tap position.

The control 260 includes an electronic processing module 261, an electronic storage 262, and an input/output (I/O) interface 263. The electronic processing module 261 includes one or more electronic processors. The electronic processors of the module 261 may be any type of electronic processor and may or may not include a general purpose central processing unit (CPU), a graphics processing unit (GPU), a microcontroller, a field-programmable gate array (FPGA), Complex Programmable Logic Device (CPLD), and/or an application-specific integrated circuit (ASIC).

The electronic storage 262 may be any type of electronic memory that is capable of storing data and instructions in the form of computer programs or software, and the electronic storage 262 may include volatile and/or non-volatile components. The electronic storage 262 and the processing module 261 are coupled such that the processing module 261 is able to access or read data from and write data to the electronic storage 262.

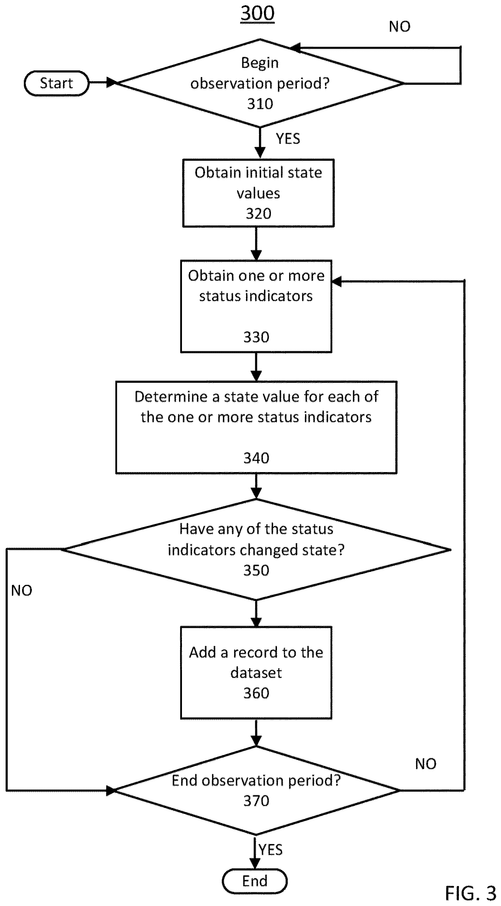

The electronic storage 262 stores executable instructions in the form of commands, functions, subroutines, and/or software. The instructions include instructions to generate the dataset 270 as discussed with respect to the process 300 (FIG. 3). The electronic storage 262 also includes instructions to analyze and process signals received from the voltage regulation device 210. For example, the electronic storage 262 stores instructions that implement a state machine 264. The electronic storage 262 also stores values and information that may be used in analyzing and processing the signals from the voltage regulation device 210. For example, the electronic storage 262 stores threshold values associated with various operating parameters of the voltage regulation system 208.

The I/O interface 263 connects the control 260 to the voltage regulation device 210 and allows the control 260 to communicate with an operator and/or a separate device. The voltage regulation device 210 is connected to the control 260 by a link 259. The link 259 is any device that is capable of carrying information, including electrical signals, data, and command signals. The control 260 obtains the regulator status indicators 292 from the voltage regulation device 210 via the link 259. The link 259 may be, for example, an electrical cable, a wire, a fiber optic cable, just to name a few. Although the link 259 is illustrated as one line, the link 259 may include more than one link (for example, more than one cable or wire), and each separate link may carry a different regulator status indicator 292 to the control 260. The I/O interface 263 includes terminals, sockets, or other wire connection points that electrically connect the link 259 to the control 260.

The I/O interface 263 may include any interface that allows a human operator and/or an autonomous process to interact with the control 260. The I/O interface 263 may include, for example, a display (such as a liquid crystal display (LCD)), a keyboard, audio input and/or output (such as speakers and/or a microphone), visual output (such as lights, light emitting diodes (LED)) that are in addition to or instead of the display, serial or parallel port, a Universal Serial Bus (USB) connection, and/or any type of network interface, such as, for example, Ethernet. The I/O interface 263 also may allow communication without physical contact through, for example, an IEEE 802.11, Bluetooth, or a near-field communication (NFC) connection. The control 260 may be, for example, operated, configured, modified, or updated through the I/O interface 263.

The I/O interface 263 also allows the control 260 to communicate with systems external to and remote from the system 208. For example, the I/O interface 263 may include a communications interface that allows communication between the control 260 and a remote station 295, or between the control 260 and a separate electrical apparatus in the power system 100 (FIG. 1) using, for example, the Supervisory Control and Data Acquisition (SCADA) protocol or another services protocol, such as Secure Shell (SSH) or the Hypertext Transfer Protocol (HTTP).

The remote station 295 is any type of station through which an operator is able to communicate with the control 260. For example, the remote station 295 may be a computer-based work station, a smart phone, tablet, or a laptop computer that connects to the control 260 via a services protocol, or a remote control that connects to the control 260 via a radio-frequency signal. The control 260 may communicate information such as the determined tap position through the I/O interface 263 to the remote station 295 or to a separate electrical apparatus. The remote station 295 includes an electronic processor, an electronic memory, and a visualization apparatus (for example, a screen). The data analysis tool 180 is stored on the electronic memory of the remote station 295 and the virtual oscilloscope trace 182 may be presented at the remote station 295.

The voltage regulation system 208 is associated with status indicators 290. The status indicators 290 are electrical signals (for example, voltage and/or current signals) that provide information about operating parameters of the voltage regulation system 208. The status indicators 290 include regulator status indicators 292 and/or control status indicators 294. The regulator status indicators 292 provide information about the operating parameters of the voltage regulation device 210. The control status indicators 294 provide information about the operating parameters of the control 260. Examples of the control status indicators 294 include, without limitation, a flag that indicates an operating status of the electronic processing module 261, a flag that indicates the presence or absence of a fault or error condition within the control 260, a flag that indicates whether or not the control 260 is connected to the voltage regulation device 210, or an electrical signal that represents a command provided to the voltage regulation device 210.

The voltage regulation device 210 also includes monitoring circuitry 233 that produces the regulator status indicators 292. The monitoring circuitry 233 monitors electrical signals (for example, voltage and/or current signals) that are produced by and/or used by components and systems within the voltage regulation device 210. The monitoring circuitry 233 outputs a signal that represents or provides information about the monitored signal. For example, the monitoring circuitry 233 may be a voltage sensor that monitors the voltage that the voltage regulation device 210 provides to the load, a hold switch that monitors the completion and/or initiation of a tap change operation, a circuit that produces a binary output to indicate whether or not an alarm or fault is present in the voltage regulation device 210, and/or a circuit that monitors the current drawn by the motor 231. The monitoring circuitry 233 may include more than one circuit, with each circuit producing a separate regulator status indicator 292. The control 260 receives the signals produced by the monitoring circuitry 233 through the link 259. The control 260 may receive the signals produced by the monitoring circuitry 233 continuously or in response to issuing a command to the monitoring circuitry 233 to provide the signals to the control 260.

FIG. 3 is a flow chart of a process 300 for building the dataset 270. The process 300 is implemented as a collection of machine-executable instructions that are stored on the electronic storage 262, and the process 300 is performed by the electronic processing module 261. Although the process 300 is discussed with respect to the control 260, the process 300 also may be performed by the control 160 to build the dataset 170, by a control in another voltage regulation system, or by a control in an electrical system that is not necessarily a voltage regulation system.

The control 260 determines whether to begin an observation period (310). The observation period is an amount of time over which the control 260 observes the status indicators 290. The observation period may be started automatically or in response to user input. In implementations in which the control 260 is configured to start the observation period automatically, the control 260 may be programmed to begin an observation period on a periodic basis and/or after the voltage regulation device 210 has been in service for a pre-determined amount of time. In these implementations, the control 260 determines that the observation period has begun in response to the pre-programmed criteria being met.

Other implementations in which the observation period begins automatically are possible. For example, the control 260 may begin an observation period when the control 260 powers on. In some implementations, the control 260 includes a virtual oscilloscope feature that may be enabled or disabled by an end user. In these implementations, the observation period begins when the virtual oscilloscope feature is enabled while the control 260 is already powered on or when the control 260 powers on with the virtual oscilloscope feature enabled. The control 260 may power on with the feature enabled when the control was previously powered off with the virtual oscilloscope feature enabled or when the virtual oscilloscope feature is enabled by default.

In some implementations, the operator, manufacturer, end user, or owner starts an observation period by inputting a start command into the I/O interface 263. In these implementations, the control 260 determines that the observation period has begun in response to receiving the input from the I/O interface 263.

If an observation period has not started, the process 300 continues to wait for the initiation of an observation period.

If an observation period is started, the control 260 determines the state values of the status indicators 290 at the time that the observation period begins (320). The state values are provided to the state machine 264. If the state machine 264 has not been initialized, the determined state values are used to initialize the state machine 264.

To determine the state value for a status indicator 290, the control 260 determines the amplitude of the status indicator 290 or the flag value of the status indicator 290. The amplitude or flag value is compared to a threshold or specification associated with the operating parameter to which the status indicator 290 relates. For example, the status indicator 290 may be the current drawn by a hold switch that is part of the circuitry 233. The hold switch is ON when the current exceeds a first threshold value, and the hold switch is OFF when the current is less than a second threshold value. The control 260 receives the current signal (which is the status indicators 290 in this example), determines the present value of the current signal, and compares the present value to the first threshold and the second threshold. If the present value of the current signal is above the first threshold value, the hold switch is ON and the state value for the status indicator 290 is set to 1. If the present value of the current signal is below the second threshold value, the hold switch is OFF and the state value to the status indicator 290 is set to 0.

The monitored status indicators 290 continue to be obtained at the control 260 (330) and a newly determined state value for each status indicator is provided to the state machine 264. Newly determined state values are compared to the most recent state values to determine if any of the status indicators 290 have changed state. A status indicator changes state when the state value changes. Continuing the above example, if the hold circuit state value is initially 0, the state of the hold circuit is deemed to have changed relative to its initial state when the hold circuit state value becomes 1. The state machine 264 determines whether any of the status indictors 290 have changed state (350).

If no status indicators 290 have changed state, the process 300 advances to (370) and determines whether the observation period has ended. The observation period may end at a set amount of time after the beginning of the observation period, the observation period may end based on user input, or the observation period may end due to the control 260 powering off. In implementations in which the control 260 includes the virtual oscilloscope feature that may be enabled or disabled, the observation period ends when the feature is disabled.

If the observation period has not ended, the process 300 returns to (330) and continues to monitor the status indicators 290 for state changes.

If the observation period has ended, the process 300 ends and the dataset 270 for the observation period has been built. The end of the observation period indicates that the dataset 270 encompassing the state changes that occurred in the observation period is complete. However, the control 260 may continue to monitor the status indicators 290 after the observation period is over, with additional state changes being captured and stored for later analysis. The later state changes may also be stored as part of the dataset 270 and/or as separate datasets.

Returning to (350), if any of the status indicators have changed state, a record-generation event is initiated and the control 260 adds a record to the dataset 270. The record includes the state value of each status indicator 290 and a time stamp that corresponds to the time when the control 260 observed the change in state. In this way, the dataset 270 includes only state values and time stamps that are associated with at least one state change.

After adding the record to the dataset 270, the control determines whether the observation period has ended (370). If the observation period has not ended, the process 300 returns to (330) and continues to monitor the status indicators 290 for state changes. If the observation period has ended, the process 300 ends and the dataset 270 for the observation period has been built.

The process 300 may include additional features. For example, in some implementations, the dataset 270 is initialized at the beginning of the observation period. In these implementations, the control 260 initiates a record-generation event to add an initial record to the dataset 270. The initial record includes the state values of the status indicators 290 at the time when the observation period begins and a time stamp of the time at which the observation period began. When there are no other records in the dataset 270 at the time of initialization, the initial record may be considered to be a record of a state change because there are no prior state values in the dataset 270 because the dataset 270 is being initialized. In another example, the process 300 may be used to monitor one status indicator 290.

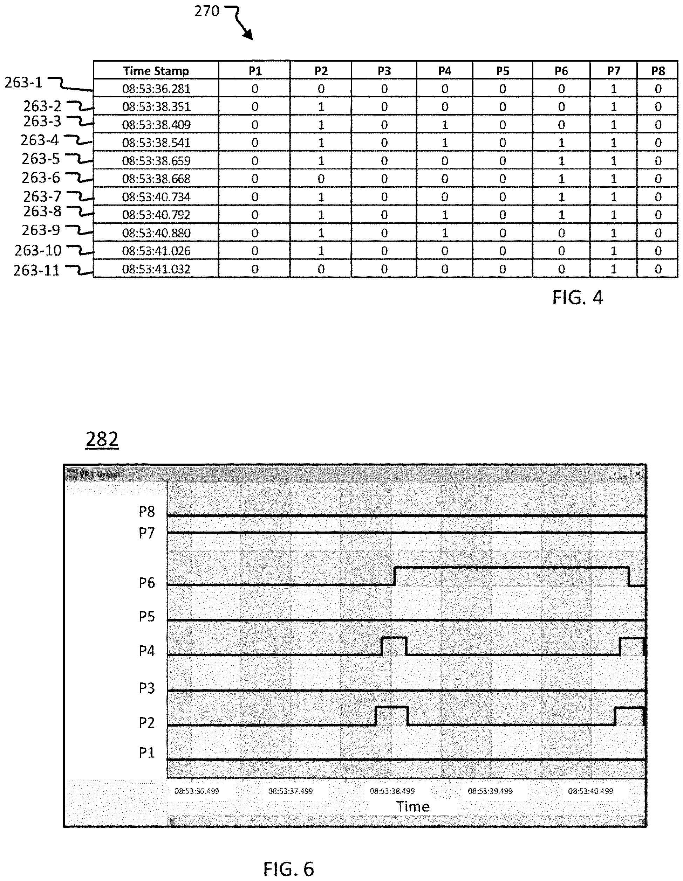

FIG. 4 is an example of the dataset 270. In the example of FIG. 4, the process 300 was used to monitor eight (8) status indicators 290 corresponding to eight (8) operating parameters P1 to P8. The operating parameters were as follows: P1, "auto tap blocked" (a status flag indicating whether or not the control 260 is in a state where it can control the voltage regulation device 210); P2, "raise motor detect" (a signal from a circuit on the control 260 when the motor 231 is rotated to raise the voltage at 102); P3, "lower motor detect" (a signal from a circuit on the control 260 when the motor 232 is rotated to lower the output voltage at 102); P4, "hold switch detect" (an output of a circuit in the voltage regulation device 210 related to current drawn by the motor 232), P5, "counter detect" (a counter in the voltage regulation device 210 that counts completed tap changes); P6, "neutral detect" (a circuit in the voltage regulation device 210 that indicates whether the tap changing mechanism 212 is in the neutral position); P7, "control auto function" (a status of a monitored input circuit in the control 260 that indicates whether or not the control 260 is configured for automatic control); and P8, "motor error" (a current signal in the regulation device 210 that indicates whether the motor 232 is functional).

The operating parameters P1, P2, P3, and P7 are examples of operating parameters of the control 260 and corresponded to signals or flags generated by circuits in the control 260. The operating parameters P4, P5, P6, and P8 are examples of operating parameters of the voltage regulation device 210 and correspond to signals produced by the monitoring circuitry 233 or other components in the voltage regulation device 210. In other words, the operating parameters P1, P2, P3, and P7 are examples of the control status indicators 294, and the operating parameters P4, P5, P6, and P8 are examples of the regulator status indicators 292.

The dataset 270 includes records 263-1 to 263-11. The record 263-1 was the first state change observed by the control 260 during the observation period. The record 263-1 includes the state values of each operating parameter P1 to P8 and the time stamp of the first observed state change (08:53:36.281). No further data was recorded in the dataset 270 until the control 260 detected a state change in the status indicator 290 corresponding to parameter P2 at a second time (08:53:38.351). The control 260 initiated the record-generating event in response to the state change and added the record 263-2 to the dataset 270. The record 263-2 includes the state value for the status indicators 290 corresponding to the operating parameters P1 to P8 and the second time (08:53:38.351) as the time stamp.

The control 260 continued to execute the process 300 and generated records 263-3, 263-4, 263-5, 263-6, 263-7, 263-8, 263-9, 263-10, 263-11 in the same way such that the dataset 270 only includes records of state changes. As is apparent from FIG. 4, the time stamps of the records in the dataset 270 are not necessarily equally spaced in time because the generation of the records 263-1 to 263-11 is driven by state changes rather than a constant sampling rate.

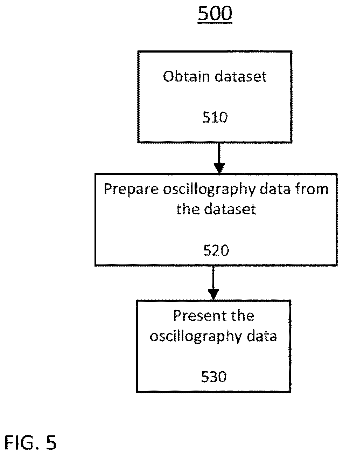

FIG. 5 is a flow chart of a process 500 for generating oscillography from the dataset 270. The process 500 is implemented by a collection of machine-executable instructions that are stored in an electronic memory at the remote station and are executed by an electronic processor at the remote station 295 (FIG 2). The process 500 is performed as part of the data tool 180, which is stored in the electronic memory of the remote station 295.

The dataset 270 is obtained from the control 260 (510). The dataset 270 may be obtained through the I/O interface 263 of the control 260. The dataset 270 may be provided to the remote station 295 using, for example, the SCADA protocol.

Oscillography data is prepared from the dataset 270 (520). Oscillography data is data that has sufficient information to produce a plot of a continuous signal over time in the way that a traditional oscilloscope would. Referring to the example of FIG. 4, the dataset 270 only includes records in which one of the status indicators 290 changed state. Thus, the state values do not change between any two consecutive records. To provide a specific example, the state values in the record 263-4 remain the same until just before the time indicated by the time stamp of the record 263-5. The oscillography data is produced by adding one or more filler records between two consecutive records, where the filler records include the same state values as the earlier of the two consecutive records. To provide a specific example, a filler record between the records 263-5 and 263-6 would have the same state values as the record 263-5: P1 (0), P2(1), P3 (0), P4 (0), P5 (0), P6 (1), P7 (1), P8 (0). The time stamp of the filler record is any time between the time stamp of the earlier record and the next record. To continue the example of the filler record between the records 263-5 and 263-6, the time stamp of the filler record may be any time between 08:53:38.659 and 08:53:38.668. Moreover, more than one filler record may be added between consecutive records.

Although the dataset 270 includes only those records that correspond to a state change of at least one status indicator 290, the dataset 270 may include other information. For example, the dataset 270 also may include state values and time stamps that do not necessarily correspond to a status change. Additionally, the dataset may include information in formats other than shown in FIG. 4. For example, the dataset 270 shown in FIG. 4 includes a time stamp that includes a time in hours, minutes, and seconds. The time stamp may take other forms. For example, the time stamp may include a date. Moreover, additional data that is not necessarily a state value of a status indicator 290 or a time stamp may be included in a record. For example, each record may also include a measured value from a sensor or other data that may aid in troubleshooting.

The oscillography data is presented (530). The oscillography data may be presented as a function of time, as shown in the virtual oscilloscope plot 282 of FIG. 6. In the example of FIG. 6, the state value of each parameter P1 to P8 is plotted as a function of time for the observation period. The x-axis is labeled with a constant sampling rate, with the time labels placed at every second. In other words, in FIG. 6, there is a one-second sampling period or one-second time period between any two adjacent time labels. The time stamps in the dataset 270 (which correspond to the state transitions of the monitored operating parameters) also may be labeled on the x-axis. As shown in FIG. 6, the state transitions that occur between two adjacent time labels are plotted. The state transitions that occur between two adjacent time labels are able to be plotted because of the information in the dataset 270.

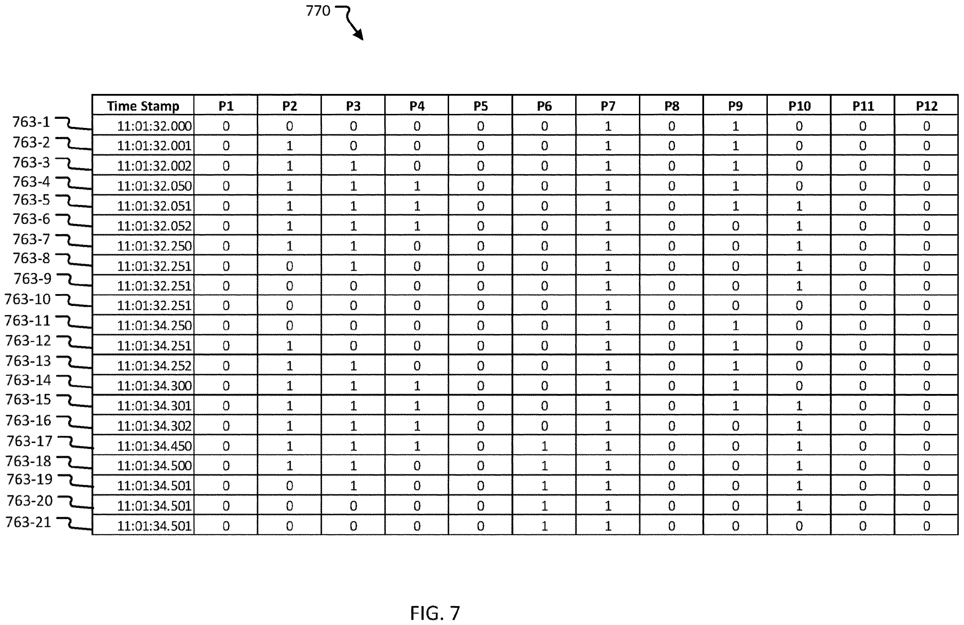

FIG. 7 is a dataset 770, which is another example of the dataset 270. To generate the dataset 770, the process 300 was used to monitor eight (12) status indicators 290 corresponding to twelve (12) operating parameters P1 to P12. The dataset 770 was generated during a different observation time period than the dataset shown in FIG. 4.

The operating parameters P1 to P8 were the same as discussed above with respect to FIG. 4: P1, "auto tap blocked" (a status flag indicating whether or not the control 260 is in a state where it can control the voltage regulation device 210); P2, "raise motor detect" (a signal from a circuit on the control 260 when the motor 231 is rotated to raise the voltage at 102); P3, "lower motor detect" (a signal from a circuit on the control 260 when the motor 232 is rotated to lower the output voltage at 102); P4, "hold switch detect" (an output of a circuit in the voltage regulation device 210 related to current drawn by the motor 232), P5, "counter detect" (a counter in the voltage regulation device 210 that counts completed tap changes); P6, "neutral detect" (a circuit in the voltage regulation device 210 that indicates whether the tap changing mechanism 212 is in the neutral position); P7, "control auto function" (a status of a monitored input circuit in the control 260 that indicates whether or not the control 260 is configured for automatic control); and P8, "motor error" (a current signal in the regulation device 210 that indicates whether the motor 232 is functional).

The operating parameters P9 to P12 were as follows: P9, "raise motor triac," (a status of an output signal of the control 260 that indicates whether or not a raise triac in the voltage regulation device 210 is closed); P10, "raise tapping active" (a status determined by the control 260 based on the operating parameters P4 and P2); P11, "lower motor triac" (a status of an output signal of the control 260 that indicates whether or not a lower triac in the voltage regulation device 210 is closed); and P12 (a status determined by the control 260 based on the operating parameters P4 and P3).

The operating parameters P1, P2, P3, P7, P9, P10, P11, and P12 are examples of operating parameters of the control 260 (or control status indicators 294). The signals or flags generated by the circuits in the control 260 include monitored parameters, such as the operating parameter P2; and also include triggers, commands, or outputs generated by the control 260, such as the operating parameters P9 and P11, and statuses determined by the control 260, such as the operating parameters P10 and P12. The operating parameters P9 and P11 are outputs or commands that are generated by the control 260 and provided to the voltage regulation device 210. For example, the operating parameter P9 has a status of ON or HIGH when the raise triac is closed based on a command issued by the control 260. The operating parameters P10 and P12 are examples of statuses that are determined by the control 260. For example, the operating parameter P10 has a status of ON or HIGH when the operating parameter P4 and the operating parameter P2 are HIGH.

The operating parameters P4, P5, P6, and P8 are examples of operating parameters of the voltage regulation device 210 and correspond to signals produced by the monitoring circuitry 233 or other components in the voltage regulation device 210.

The dataset 770 includes records 763-1 to 763-11. The record 763-1 was the first state change observed by the control 260 during the observation period. The record 763-1 includes the state values of each operating parameter P1 to P12 and the time stamp of the first observed state change (11:01:32.000). No further data was recorded in the dataset 770 until the control 260 detected a state change in the status indicator 290 corresponding to parameter P2 at a second time (11:01:32.001). The control 260 initiated the record-generating event in response to the state change and added the record 763-2 to the dataset 770. The record 763-2 includes the state value for the status indicators 290 corresponding to the operating parameters P1 to P12 and the second time (11:01:32.001) as the time stamp.

The control 260 continued to execute the process 300 and generated records 763-3 to 763-21 in the same way such that the dataset 770 only includes records with a state change in at least one status indicator 290. As is apparent from FIG. 7, the time stamps of the records in the dataset 770 are not necessarily equally spaced in time because the generation of the records 763-1 to 763-21 is driven by state changes rather than a constant sampling rate.

The data in the dataset 770 may be visualized using the process 500.

The above implementations and other implementations are within the scope of the claims.

## Claims

1. A control system comprising:
a data monitoring module configured to:
obtain one or more status indicators of a voltage regulation system, each status indicator corresponding to an operating parameter of the voltage regulation system;
determine a state value of each status indicator at a second time;
compare the state value of each status indicator to a state value for that status indicator at a first time, the first time occurring before the second time;
determine whether any operating parameter of the voltage regulation system changed state based on the comparison; and
if any operating parameter of the voltage regulation system changed state, store a record in a dataset, the record comprising the state value of all of the status indicators and a time stamp that comprises the second time.

2. The control system of claim 1, wherein the status indicators comprise regulator status indicators that correspond to operating parameters of a voltage regulation device coupled to the control system, and control status indicators that correspond to operating parameters of the control system.

3. The control system of claim 1, wherein the data monitoring module is further configured to provide the dataset to a separate device.

4. The control system of claim 3, wherein the data monitoring module is configured to provide the dataset to the separate device using the SCADA protocol.

5. The control system of claim 1, wherein the data monitoring module is further configured to provide the dataset to a display module that is configured to visually present oscillography based on the dataset, and wherein the display module visually presents the oscillography at a voltage regulation device or at a separate device.

6. The control system of claim 5, wherein the display module is part of the control system.

7. The control system of claim 2, wherein the control status indicators comprise one or more of an indicator related to an operating status of the control system, an indicator related to a command issued by the control system, an indicator related to a command received by the voltage regulation device, and an indicator related to a monitored value.

8. The control system of claim 2, wherein the control status indicators comprise one or more indicators that are determined based on a plurality of other status indicators.

9. A method comprising:
monitoring the state of one or more operating parameters of an electrical system during an observation period to detect changes in the state of the one or more operating parameters; and
in response to detecting a change in the state of any of the one or more operating parameters at a time in the observation period:
generating a record that comprises one or more values and a time stamp, the one or more values each representing the state of one operating parameter at the time in the observation period and the time stamp comprising the time in the observation period; and
adding the generated record to a dataset such that the dataset includes records of state changes.

10. The method of claim 9, further comprising:
generating oscillography data based on the dataset; and
presenting a virtual oscilloscope trace based on the oscillography data.

11. The method of claim 9, wherein monitoring the state of the one or more operating parameters comprises monitoring status indicators corresponding to the one or more operating parameters, and detecting changes in the state of a particular one of the operating parameters comprises comparing a state value of the status indicator corresponding to that operating parameter at a later time to the state value of that status indicator at an earlier time.

12. A system comprising:
a data management module configured to:
obtain a dataset comprising records, each record representing a state change of at least one operating parameter of an electrical system during an observation period, wherein each record comprises state values of the operating parameters and a time stamp, each time stamp being a time during the observation period when a state change for at least one operating parameter was detected; and
prepare oscillography data from the dataset by generating at least one filler record and adding the least one filler record between a first record in the dataset and a second record in the dataset, the first record having an earlier time stamp than the second record, and the filler record comprising the same state values as the first record and a time stamp between the time stamp of the first record and the time stamp of the second record; and
a visualization module configured to present a graph comprising the values in the oscillography data plotted as a function of time for the observation period.

13. The system of claim 12, wherein the time stamps in the oscillography data include time stamps that are equally spaced in time, and the time stamps in the dataset are not equally spaced in time.

14. The system of claim 12, wherein the visualization module is further configured to visually present the time stamps of the dataset to thereby provide temporal labels for state transitions.

15. The system of claim 12, wherein each record represents a state change of at least one operating parameter of a voltage regulator.
